# EUROPÄISCHE PATENTSCHRIFT

(11) **EP 2 704 194 B1**
(45) Veröffentlichungstag und Bekanntmachung des Hinweises auf die Patenterteilung: **19.06.2019**
(21) Anmeldenummer: 13175257.8
(22) Anmeldetag: 05.07.2013
(51) Int. Cl.: H01L 25/07, H01L 23/495, H01L 23/00, H01L 23/373, H01L 23/498

(54) **Leistungshalbleitermodul und Verfahren zur Herstellung eines Leistungshalbleitermoduls**
Semiconductor power module and method for manufacturing the same
Module semi-conducteur de puissance et procédé de fabrication d'un module semi-conducteur de puissance

(30) Priorität: 04.09.2012 DE 102012215656
(43) Veröffentlichungstag der Anmeldung: 05.03.2014
(73) Patentinhaber: Semikron Elektronik GmbH & Co. KG Patentabteilung, 90431 Nürnberg (DE)
(72) Erfinder: Göbl, Christian, 90441 Nürnberg (DE); Steger, Jürgen, 91355 Hiltpoltstein (DE)

(56) Entgegenhaltungen:
- US-A1- 2003 137 040
- US-A1- 2008 283 983
- US-A1- 2012 061 815

## Beschreibung

Die Erfindung betrifft ein Leistungshalbleitermodul und Verfahren zur Herstellung eines Leistungshalbleitermoduls.

Leistungshalbleiterschalter, wie z.B. IGBTs (Insulated Gate Bipolar Transistor), MOSFETs (Metal Oxide Semiconductor Field Effect Transistor) oder Thyristoren, werden unter anderem z.B. zum Gleichrichten und Wechselrichten von elektrischen Spannungen und Strömen verwendet, wobei in der Regel mehrere Leistungshalbleiterschalter, z.B. zur Realisierung eines Stromrichters, elektrisch miteinander verbunden werden. Die Leistungshalbleiterschalter sind dabei im Allgemeinen auf einem Substrat angeordnet, das in der Regel direkt oder indirekt mit einem Kühlkörper verbunden ist.

Leistungshalbleiterschalter, welche üblicherweise in Form eines ungehausten Leistungshalbleiterchips vorliegen, werden zur Herstellung eines Leistungshalbleitermoduls auf einem Substrat angeordnet und mit dem Substrat in der Regel über eine Lötverbindung verbunden. Das Substrat kann z.B. in Form eines DCB- oder IMS-Substrats vorliegen. Das Substrat weist eine strukturierte elektrisch leitende Metallschicht auf, die infolge Ihrer Struktur Leiterbahnen ausbildet. Die Leistungshalbleiterschalter werden über die Leiterbahnen miteinander verbunden, so dass durch die Leistungshalbleiterschalter fließende Lastströme, welche eine hohe Stromstärke aufweisen können, auch durch die Leiterbahnen der elektrisch leitenden Metallschicht fließen. Die Lastströme fließen dabei z.B. von dem Leistungshalbleitermodul zu einer mit den Leistungshalbleitermodul verbunden Last, wie z.B. einem Elektromotor. Zur Herstellung z.B. eines DCB-Substrats werden techniküblich ein Metallblech einheitlicher Dicke auf einen Isolierstoffkörper, der üblicherweise aus einer Keramik besteht, gebondet und anschließend die Leiterbahnenstruktur aus dem Metallblech geätzt. Zur Herstellung eines IMS-Substrat wird techniküblich ein Metallblech einheitlicher Dicke über eine Isolationsschicht mit einem Metallkörper verbunden und anschließend die Leiterbahnenstruktur aus dem Metallblech geätzt. Die mögliche Höhe der durch die Leiterbahnen fließenden Lastströme hängt dabei im nicht unerheblichen Maße von der Dicke des Metallblechs ab. Ein dickes Metallblech erlaubt die Realisierung von besonderes stromtragfähigen Leiterbahnen, da die Leiterbahnen einen großem Querschnitt aufweisen und das dicke Metallblech eine gute Wärmespreizung der von den Leistungshalbleiterschaltern abgegebenen Wärme ermöglicht.

Da bei handelsüblichen Substraten die Leiterbahnenstruktur aus dem Metallblech herausgeätzt wird, ist die realisierbare Dicke der Leiterbahnen bzw. des Metallblechs begrenzt, da beim Herausätzen der Leiterbahnenstruktur aus dem Metallblech, das Ätzmittel, das in der Regel in Form einer Säure vorliegt, auch Material seitlich unter dem Abdecklack, der die Stellen abdeckt an denen die Leiterbahnen entstehen sollen, aus dem Metallblech herausätzt bzw. die durch Ätzen entstandenen Aussparungen eine trapezförmige Struktur aufweisen und somit mit zunehmender Eindringtiefe der Säuere sich die Breite der Aussparungen verkleinert und somit keine zuverlässige elektrische Isolation zwischen den durch die Aussparungen getrennten Leitbahnen mehr gegeben ist. Bei handelsüblichen Substraten ist somit die Dicke des Metallblechs aus denen die Leiterbahnen herausgeätzt werden können begrenzt und infolge die Stromtragefähigkeit des Leistungshalbleitermodul eingeschränkt.

Weiterhin werden in der Regel die Leistungshalbleiterschalter mittels einer Lötverbindung mit den Leiterbahnen verbunden. Infolge des relativ niedrigen Schmelzpunkts des Lots ist eine Lötverbindung aber insbesondere bei Auftreten von hohen Lastströmen nicht langzeitstabil.

Aus der DE 102 13 648 A1 ist die Verwendung von gehausten Leistungshalbleiterbauelementen zur Verbindung mit einem DCB-Substrat bekannt.

Aus der US 2012/0061815 A1 ist ein Leistungshalbleitermodul mit einem Substrat, mindestens einem Leistungshalbleiterbauelement, und mindestens einem ersten Leadframe-Element bekannt, wobei das mindestens eine erste Leadframe-Element auf einer ersten Oberfläche mit dem Leistungshalbleiterbauelement verbunden ist und auf einer zweiten, der ersten gegenüberliegenden, Oberfläche mit dem Substrat verbunden ist, wobei sowohl die Verbindung zwischen dem mindestens einen ersten Leadframe-Element und dem Leistungshalbleiterbauelement, wie auch die Verbindung zwischen dem ersten Leadframe-Element und dem Substrat eine Metallsinterverbindung umfassen.

Aus der US 2003/0137040 A1 ist ein Leistungshalbleitermodul, das Halbleiterchips und einen Clip aufweist, wobei der Clip als elektrisches Verbindungselement dient, bekannt.

Es ist Aufgabe der Erfindung ein zuverlässiges Leistungshalbleitermodul zu schaffen.

Diese Aufgabe wird gelöst durch ein Leistungshalbleitermodul, wobei das Leistungshalbleitermodul einen elektrisch leitenden Metallformkörper und eine strukturierte, elektrisch leitende Metallblechelemente aufweisende, Metallblechanordnung aufweist, die über eine elektrisch nicht leitende Isolationsschicht mit dem Metallformkörper verbunden ist, wobei die Metallblechelemente in Richtung der Isolationsschicht senkrecht zur Isolationsschicht verlaufende Seitenkanten aufweisen, wobei das Leistungshalbleitermodul einen gehausten Leistungshalbleiterschalter aufweist, der über eine zwischen dem gehausten Leistungshalbleiterschalter und der Metallblechanordnung angeordnete Sinterschicht mit der Metallblechanordnung verbunden ist, wobei der gehauste Leistungshalbleiterschalter an seiner der Isolationsschicht zugewandten Seite elektrisch leitende Anschlussflächen aufweist, wobei die jeweilige Anschlussfläche mit einem ihr zugeordneten jeweiligen Metallblechelement verbunden ist.

Weiterhin wird die Aufgabe gelöst durch ein Verfahren zur Herstellung eines Leistungshalbleitermoduls mit folgenden Verfahrensschritten:
a) Bereitstellen eines elektrisch leitenden Metallformkörpers und einer strukturierten, elektrisch leitende Metallblechelemente aufweisenden, Metallblechanordnung, wobei die Metallblechelemente mittels einer, einstückig mit den Metallblechelementen ausgebildeten, Metallblechelementverbindungsvorrichtung miteinander verbunden sind,
b) Verbinden der Metallblechanordnung mit dem Metallformkörper über eine elektrisch nicht leitende Isolationsschicht,
c) Verbinden eines gehausten Leistungshalbleiterschalters mit der Metallblechanordnung mittels einer Sinterverbindung, wobei der gehauste Leistungshalbleiterschalter an seiner der Isolationsschicht zugewandten Seite elektrisch leitende Anschlussflächen aufweist, wobei die jeweilige Anschlussfläche mit einem ihr zugeordneten jeweiligen Metallblechelement verbunden wird, und
d) Abtrennen der Metallblechelementverbindungsvorrichtung von der Metallblechanordnung.

Vorteilhafte Ausbildungen des Verfahrens ergeben sich analog zu vorteilhaften Ausbildungen des Leistungshalbleitermoduls und umgekehrt.

Vorteilhafte Ausbildungen der Erfindung ergeben sich aus den abhängigen Ansprüchen.

Es erweist sich als vorteilhaft, wenn mindestens ein Metallblechelement einen von der Isolationsschicht weg verlaufenden Abschnitt aufweist. Durch diese Maßnahme kann auf einfache Art und Weise ein einstückig mit dem Metallblechelement ausgebildetes Last-, Steuer- oder Hilfsanschlusselement realisiert werden.

Weiterhin erweist es sich als vorteilhaft, dass der gehauste Leistungshalbleiterschalter an seiner der Isolationsschicht zugewandten Seite elektrisch leitende Anschlussflächen aufweist, wobei die jeweilige Anschlussfläche mit einem ihr zugeordneten jeweiligen Metallblechelement verbunden ist. Hierdurch wird eine zuverlässige elektrische Anbindung des Leistungshalbleiterschalters an die Metallblechanordnung ermöglicht.

Weiterhin erweist es sich als vorteilhaft, wenn das Leistungshalbleitermodul einen elektrisches Widerstandselement aufweist, das über eine zwischen dem Widerstandselement und der Metallblechanordnung angeordnete Sinterschicht mit der Metallblechanordnung verbunden ist, da dann das Widerstandselement besonderes zuverlässig mit der Metallblechanordnung verbunden ist.

Ferner erweist es sich als vorteilhaft, wenn das Leistungshalbleitermodul ein Steueranschlusselement und/oder Hilfsanschlusselement aufweist, das mit der Metallblechanordnung mittels einer Schweiß- oder Sinterverbindung verbunden ist, da dann das Steueranschluss und/oder das Hilfsanschlusselement auf einfache Art und Weise an unterschiedliche Kontaktverbindungsausführungen von verschiedenen Steuereinheiten, die zur Steuerung des Leistungshalbleitermoduls ausgebildet sind, variabel angepasst werden kann.

Weiterhin erweist es sich als vorteilhaft, wenn der Metallformkörper eine Dicke von 3 mm bis 10 mm oder mehr aufweist, da dann der Metallformkörper ein großes Wärmaufnahmevermögen aufweist und eine gute Wärmespreizung ermöglicht.

Ferner erweist es sich als vorteilhaft, wenn die Isolationsschicht eine Dicke von 20 µm bis 60 µm aufweist, da dann eine zuverlässige elektrische Isolierung sichergestellt ist.

Ferner erweist es sich als vorteilhaft, wenn die Metallblechanordnung eine Dicke von 0,5 mm bis 1 mm oder mehr aufweist, dann die Stromtragefähigkeit des Leistungshalbleitermoduls hoch ist.

Weiterhin erweist es sich als vorteilhaft, wenn der gehauste Leistungshalbleiterschalter als SMD-Bauelement ausgebildet ist, da dann das Leistungshalbleitermodul besonders klein gebaut werden kann.

Weiterhin erweist es sich als vorteilhaft, wenn ein Verbiegen eines Abschnitts von mindestens einem Metallblechelement von der Isolationsschicht weg erfolgt. Durch diese Maßnahme kann auf einfache Art und Weise ein einstückig mit dem Metallblechelement ausgebildetes Last-, Steuer- oder Hilfsanschlusselement realisiert werden.

Ausführungsbeispiele der Erfindung sind in den Figuren dargestellt und werden im Folgenden näher erläutert. Dabei zeigen:
- FIG 1: ein Leistungshalbleitermodulrohling nach Durchführung mehrerer erfindungsgemäßer Verfahrensschritte in Form einer schematisierten perspektivischen Darstellung,
- FIG 2: eine zu FIG 1 zugehörige schematisierte Schnittdarstellung des Leistungshalbleitermodulrohlings,
- FIG 3: ein erfindungsgemäßes Leistungshalbleitermodul in Form einer schematisierten perspektivischen Darstellung und
- FIG 4: ein weiteres erfindungsgemäßes Leistungshalbleitermodul in Form einer schematisierten perspektivischen Darstellung.

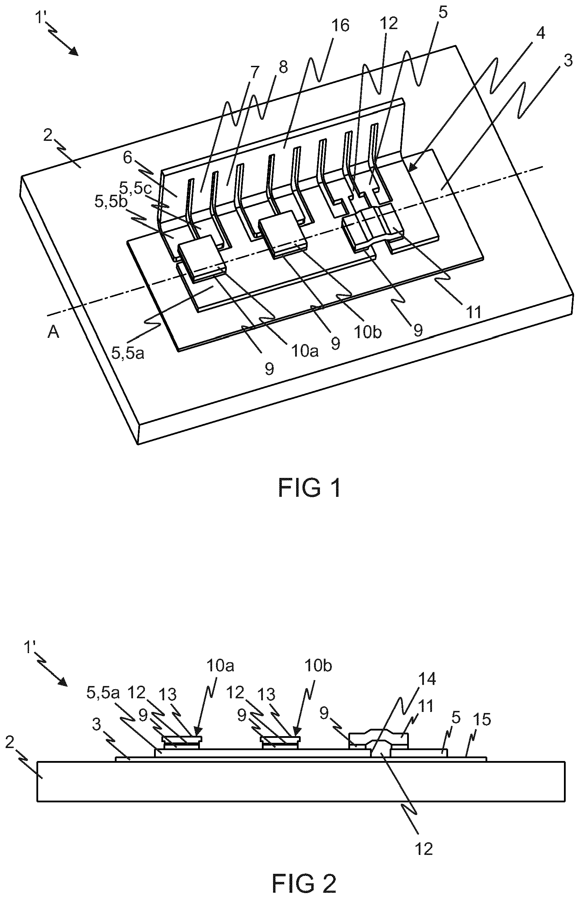

Im Folgenden wird ein erfindungsgemäßes Verfahren zur Herstellung eines erfindungsgemäßen Leistungshalbleitermoduls beschrieben. In FIG 1 ist ein Leistungshalbleitermodulrohling 1' nach Durchführung mehrerer erfindungsgemäßer Verfahrensschritte in Form einer schematisierten perspektivischen Darstellung dargestellt. In FIG 2 ist eine zu FIG 1 zugehörige schematisierte Schnittdarstellung des Leistungshalbleitermodulrohlings 1' eines entlang der Line A verlaufenden Schnitts dargestellt.

In einem ersten Verfahrensschritt erfolgt ein Bereitstellen eines elektrisch leitenden Metallformkörpers 2 und einer strukturierten, elektrisch leitende Metallblechelemente 5 aufweisenden, Metallblechanordnung 4, wobei die Metallblechelemente 5 mittels einer, einstückig mit den Metallblechelementen 5 ausgebildeten Metallblechelementverbindungsvorrichtung 16, miteinander verbunden sind. Der Metallformkörper kann z.B. aus Aluminium oder einer Aluminiumlegierung bestehen. Der Metallformkörper kann z.B. in Form einer Metallplatte vorliegen. Der Metallformkörper weist vorzugsweise eine Dicke von 3 mm bis 10 mm, insbesondere eine Dicke von 5 mm bis 10 mm auf. Die Metallblechanordnung 4 besteht aus einem Metallblech aus dem z.B. mittels Stanzen oder einer Laserbearbeitung Material aus dem Metallblech entfernt bzw. herausgestanzt wurde, so dass das Metallblech Aussparungen aufweist, wobei in FIG 1 der Übersichtlichkeit halber nur eine Aussparung 12 mit einem Bezugszeichen versehen ist. Das Metallblech liegt solchermaßen in Form eines sogenannten Leadframes vor. Durch die Aussparungen weist die Metallblechanordnung 4 eine Struktur auf, die die Metallblechelemente 5 ausbildet. Die Metallblechelemente 5 sind durch die Aussparungen voneinander getrennt. Die Metallblechelemente 5 bilden in Verbindung mit den Aussparungen elektrische Leiterbahnen aus. Die Metallblechelementen 5 sind mittels einer einstückig mit den Metallblechelementen 5 ausgebildeten Metallblechelementverbindungsvorrichtung 16, miteinander verbunden. Die Metallblechanordnung 4 besteht vorzugsweise aus Kupfer oder einer Kupferlegierung. Die Metallblechanordnung 4, genauer ausgedrückt die Metallblechelemente 5, weist/weisen vorzugweise eine Dicke von 0,5 mm bis 1 mm auf.

In einem weiteren Verfahrensschritt erfolgt ein Verbinden der Metallblechanordnung 4 mit dem Metallformkörper 2 über eine elektrisch nicht leitende Isolationsschicht 3. Die elektrisch nicht leitende Isolationsschicht 3 bewirkt eine elektrische Isolation der Metallblechanordnung 4 von dem Metallformkörper 2 und kann z.B. aus Polyimid oder Epoxy bestehen. Die Isolationsschicht 3 weist vorzugsweise eine Dicke von 20 µm bis 60 µm auf. Zum Verbinden der Metallblechanordnung 4 mit dem Metallformkörper 2 wird die elektrische Isolationsschicht 3 auf den Metallformkörper 2 aufgetragen und anschließend die Metallblechanordnung 4 auf der Isolationsschicht 3 angeordnet.

In einem weiteren Verfahrensschritt erfolgt im Rahmen des Ausführungsbeispiels ein Verbinden eines ersten und eines zweiten gehausten Leistungshalbleiterschalters 10a und 10b, sowie eines elektrischen Widerstandselements 11 mit der Metallblechanordnung 4 mittels einer Sinterverbindung. Hierzu wird beim Ausführungsbeispiel an den Stellen an denen der erste und der zweite gehauste Leistungshalbleiterschalter 10a und 10b, mit den Metallblechelementen 5 der Metallblechanordnung 4 verbunden werden soll, eine Sinterpaste aufgetragen und die beiden gehausten Leistungshalbleiterschalter 10a und 10b und das Widerstandselements 11 auf die mit Sinterpaste versehenen Bereiche der Metallblechelemente 5 angeordnet und anschließend unter Druck- und Temperatureinwirkung mit den Metallblechelementen 5 verbunden, so dass zwischen dem ersten und dem zweiten gehausten Leistungshalbleiterschaltern 10a und 10b und dem Widerstandselements 11, und der Metallblechanordnung 4 eine Sinterschicht 9 angeordnet ist. Die Leistungshalbleiterschalter 10a und 10b weisen jeweilig ein Gehäuse 13 auf, indem ein Leistungshalbleiterchip angeordnet ist, wobei der Übersichtlichkeitshalber der Leistungshalbleiterchip in FIG 2, sowie das weitere Innere des Gehäuses 13 in FIG 2 nicht dargestellt sind. Das Gehäuse 13 kann z.B. in Form eines TO Gehäuses vorliegen. Gehauste Leistungshalbleiterschalter sind Stand der Technik. Die gehausten Leistungshalbleiterschalter 10a und 10b liegen beim Ausführungsbespiel in Form von MOSFETs vor und weisen an ihrer den Metallblechelementen 5 zugewandten Seite elektrische Anschlussflächen auf, die zum elektrischen Verbinden des im Inneren des Gehäuses 13 angeordneten Leistungshalbleiterchips mit der Außenwelt dienen. In der Schnittdarstellung in FIG 2 ist eine der Anschlussflächen des ersten und zweiten Leistungshalbleiterschalters 10a und 10b mit dem Bezugseichen 12 versehen. Die Anschlussflächen der gehausten Leistungshalbleiterschalter dienen dabei neben dem elektrischen Verbinden auch zur Wärmeabgabe der Leistungshalbleiterschalter an die Metallblechanordnung 4.

Beim Ausführungsbeispiel weisen die beiden gehausten Leistungshalbleiterschalter 10a und 10b jeweilig drei Anschlussflächen auf. Die Anschlussfläche 12 des ersten gehausten Leistungshalbleiterschalter 10a, welche gehäuseintern mit dem Source des Leistungshalbleiterchips elektrisch leitend verbunden ist, ist mit dem Metallblechelemente 5a verbunden. Die Anschlussfläche des ersten gehausten Leistungshalbleiterschalter 10a, welche gehäuseintern mit der Drain des Leistungshalbleiterchips elektrisch leitend verbunden ist, ist mit dem Metallblechelemente 5b verbunden und die Anschlussfläche des ersten gehausten Leistungshalbleiterschalter 10a, welche gehäuseintern mit dem Gate des Leistungshalbleiterchips elektrisch leitend verbunden ist, ist mit dem Metallblechelement 5c verbunden. Die Verbindungen zu den jeweiligen Metallblechen sind dabei über die Sinterschicht 9 realisiert. Die Anschlussflächen bestehen dabei in der Regel aus Kuper oder aus einer Kupferlegierung. Es sei an dieser Stelle angemerkt, dass die Anschlussflächen der gehausten Leistungshalbleiterschalter und/oder die den Anschlussflächen der gehausten Leistungshalbleiterschalter zugewandte Fläche der Metallblechanordnung 4 bzw. der Metallblechelemente 5, gegebenenfalls eine Oberflächenbeschichtung, z.B. aus Silber, aufweisen kann, die vorzugsweise als Haftvermittlungsschicht für die Sinterverbindung 9 dient.

Es sei an dieser Stelle angemerkt, dass das Gehäuse 13 des gehausten Leistungshalbleiterschalter nicht nur den eigentlichen Leistungshalbleiterchip (z.B. MOSFET, IGBT oder Thyristor) enthalten kann, sondern gegebenenfalls auch weitere elektrische Bauelemente enthalten kann. Beim Ausführungsbeispiel ist z.B. in dem jeweiligen Gehäuse 13 des ersten und zweiten gehausten Leistungshalbleiterschalters 10a und 10b auch eine zum jeweiligen Leistungshalbleiterchip elektrisch antiparallel geschaltete Diode angeordnet.

Die gehausten Leistungshalbleiterschalter können z.B. als SMD-Bauelemente ausgebildet sein.

Dadurch dass erfindungsgemäß zur Herstellung der strukturierten Metallblechanordnung 4 kein Ätzprozess wie bei techniküblichen Substraten verwendet wird, weisen die Metallblechelemente 5 in Richtung der Isolationsschicht 3 senkrecht zur Isolationsschicht 3 verlaufende Seitenkanten auf. In FIG 2 ist dabei der Übersichtlichkeit halber nur eine Seitenkante 14 der Metallblechelemente 5 mit einem Bezugszeichen versehen. Die Seitenkanten der Metallblechelemente 5 verlaufen senkrecht zur Hauptfläche 15 der Metallblechelemente 5. Die Metallblechanordnung 4 bzw. die Metallblechelemente 5 und die aus ihnen gebildete Leiterbahnen können somit praktisch eine beliebige Dicke aufweisen und infolge für sehr hohe Lastströme ausgelegt werden. Die zwischen den Metallblechelementen 5 angeordneten Aussparungen 12 weisen somit längs ihrer gesamten Dicke eine einheitliche Breite und somit eine konstante Isolationsfestigkeit auf, die unabhängig von der Dicke der Metallblechelemente 5 ist. Infolge der realisierbaren großen Dicke der Metallblechanordnung 4 bzw. der Metallblechelemente 5 ermöglicht die Metallblechanordnung 4 eine gute Wärmespreizung, der von den gehausten Leistungshalbleiterschaltern beim Betrieb des erfindungsgemäßen Leistungshalbleitermoduls an die Metallblechanordnung 4 abgegebenen Wärme.

Weiterhin werden erfindungsgemäß nicht wie bei techniküblichen Substraten die Leistungshalbleiterchips direkt mit einem Substrat verbunden, sondern es werden gehauste Leistungshalbleiterschalter verwendet und diese mit der Metallblechanordnung 4 verbunden. Hierdurch wird vermieden, dass es infolge der unterschiedlichen Wärmeausdehnungskoeffizienten der Metallblechanordnung 4 und des Leistungshalbleiterchips zu einer Zerstörung des Leistungshalbleiterchips bei starken Temperaturschwankungen, welche insbesondere bei Lastwechsel von hohen Lastströmen auftreten können, kommt.

Durch die erfindungsgemäße Verwendung einer Sinterverbindung anstatt der techniküblichen Lötverbindung zur Herstellung der elektrischen Verbindungen der gehausten Leistungshalbleiterschalter mit der Metallblechanordnung wird eine hochtemperaturfeste Verbindung der Leistungshalbleiterschalter mit der Metallblechanordnung realisiert, die auch einer bei hohen Lastströmen auftretenden starken Erwärmung zuverlässig dauerhaft standhält.

Durch das erfindungsgemäße kombinatorische Zusammenwirken, der Merkmale der Metallblechanordnung, der Verwendung von gehausten Leistungshalbleiterschaltern und der Verwendung einer Sinterverbindung zur Verbindung der gehausten Leistungshalbleiterschalter mit der Metallblechanordnung wird ein, insbesondere auch bei hohen Lastströmen, sehr zuverlässiges Leistungshalbleitermodul ermöglicht.

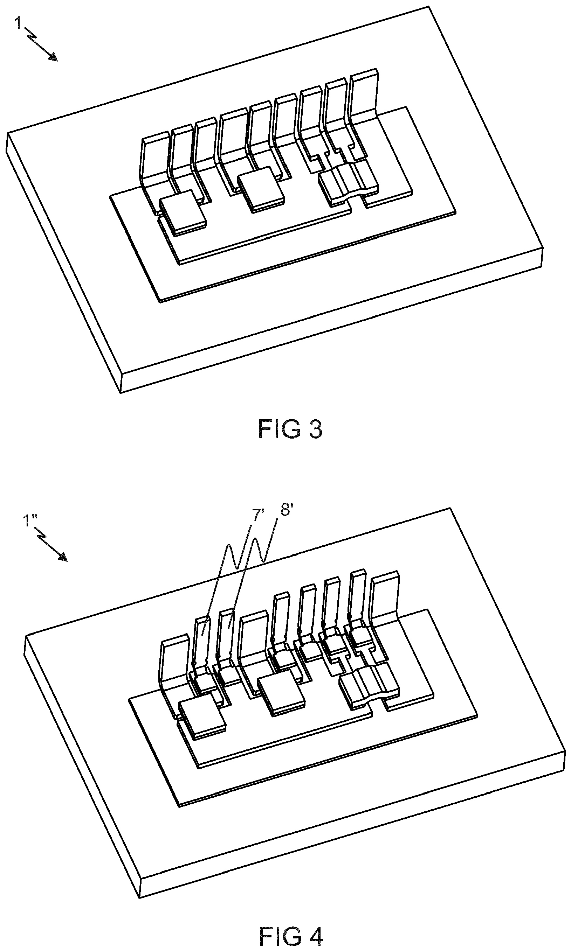

In einem weiteren Verfahrensschritt erfolgt ein Abtrennen der Metallblechelementverbindungsvorrichtung 16 von der Metallblechanordnung, so dass das in FIG 3 dargestellte erfindungsgemäße Leistungshalbleitermodul 1 entsteht.

Dieser Verfahrensschritt kann auch zwischen dem Verbinden der Metallblechanordnung mit dem Metallformkörper und dem Verbinden der gehausten Leistungshalbleiterschalter mit der Metallblechanordnung erfolgen.

Vorzugsweise weisen die Metallblechelemente 5 einen von der Isolationsschicht 3 weg verlaufenden Abschnitt auf, insbesondere einen senkrecht weg von der Isolationsschicht 3 verlaufenden Abschnitt auf. Beim Ausführungsbeispiel sind der Übersichtlichkeit halber in FIG 1 nur die Abschnitte 6, 7 und 8 der Metallblechelemente 5 mit einem Bezugszeichen versehen. Der Abschnitt 6 bildet dabei ein Lastanschlusselement, mit dem das Leistungshalbleitermodul 1 mit der Außenwelt elektrisch verbunden wird und durch das im Betrieb des Leistungshalbleitermoduls 1 Lastströme fließen. Der Abschnitt 7 bildet dabei ein Steueranschlusselement, mit dem das Leistungshalbleitermodul 1 mit der Außenwelt elektrisch verbunden wird und mittels dem im Betrieb des Leistungshalbleitermoduls 1 der gehauste Leistungshalbschalter 10a gesteuert, d.h. ein- und ausgeschaltet wird. Der Abschnitt 8 bildet dabei ein Hilfsanschlusselement, mit dem das Leistungshalbleitermodul 1 mit der Außenwelt elektrisch verbunden wird und mittels dem im Betrieb des Leistungshalbleitermoduls 1, beim Ausführungsbeispiel z.B. eine am gehausten Leistungshalbschalter 10a auftretende elektrische Spannung, gemessen wird.

Das elektrische Widerstandselement 11 dient im Rahmen des Ausführungsbeispiels als Shunt zur Messung des durch ihn fließenden Laststroms.

Beim Ausführungsbeispiel ist die Metallblechanordnung schon vor Beginn des erfindungsgemäßen Verfahren entsprechend gebogen, so dass die Metallblechelemente 5 der Metallblechanordnung 4 schon zu Beginn des Verfahrens von der Isolationsschicht 3 weg verlaufende Abschnitte aufweisen.

Falls die Metallblechanordnung nicht bei Beginn des erfindungsgemäßen Verfahren schon entsprechend gebogen ist und ein Abschnitt von mindestens einem Metallblechelement von der Isolationsschicht 3 weg stehen soll, kann in einen zusätzlichen Verfahrensschritt ein Verbiegen eines Abschnitts von mindestens einem Metallblechelement von der Isolationsschicht 3 weg, insbesondere senkrecht von der Isolationsschicht 3 weg, erfolgen. Durch diese Maßnahme kann auf einfache Art und Weise ein einstückig mit dem Metallblechelement ausgebildetes, von der Isolationsschicht weg stehendes Last-, Steuer- oder Hilfsanschlusselement realisiert werden. Der zusätzliche Verfahrensschritt kann entweder unmittelbar nach dem Verbinden der Metallblechanordnung mit dem Metallformkörper 2 oder unmittelbar nach dem Verbinden des gehausten Leistungshalbleiterschalters mit der Metallblechanordnung 4, oder unmittelbar nach dem Abtrennen der Metallblechelementverbindungsvorrichtung 16 von der Metallblechanordnung 4, erfolgen.

In FIG 4 ist ein weiteres erfindungsgemäßes Leistungshalbleitermodul 1" in Form einer perspektivischen Darstellung dargestellt. Das erfindungsgemäße Leistungshalbleitermodul 1" entspricht dabei dem erfindungsgemäßen Leistungshalbleitermodul 1 mit dem Unterschied, dass das Leistungshalbleitermodul 1" Steueranschlusselemente und/oder Hilfsanschlusselemente aufweist, die mit der Metallblechanordnung mittels einer Schweiß- oder Sinterverbindung verbunden sind. Beim Ausführungsbeispiel sind die Steueranschlusselemente und die Hilfsanschlusselemente mittels einer Schweißverbindung miteinander verbunden. In FIG 4 ist der Übersichtlichkeit halber nur ein Steueranschlusselement 7' und ein Hilfsanschlusselement 8' mit einem Bezugszeichen versehen. Die Steueranschlusselemente und/oder die Hilfsanschlusselemente sind somit beim Leistungshalbleitermodul 1" im Gegensatz zum Leistungshalbleitermodul 1 nicht einstückig mit denen ihnen jeweilig zugeordneten Metallblechelementen ausgebildet. Die Steueranschlusselemente und/oder die Hilfsanschlusselemente sind bei diesem Ausführungsbeispiel auf einfache Art und Weise an unterschiedliche Kontaktverbindungsausführungen von verschiedenen Steuereinheiten, die zur Steuerung des Leistungshalbleitermoduls ausgebildet sind, variabel anpassbar.

Es sei an dieser Stelle angemerkt, dass gleiche Elemente in den Figuren mit den gleichen Bezugszeichen versehen sind.

## Patentansprüche

1. Leistungshalbleitermodul, wobei das Leistungshalbleitermodul (1,1") einen elektrisch leitenden Metallformkörper (2) und eine strukturierte, elektrisch leitende Metallblechelemente (5) aufweisende, Metallblechanordnung (4) aufweist, die über eine elektrisch nicht leitende Isolationsschicht (3) mit dem Metallformkörper (2) verbunden ist, wobei die Metallblechelemente (5) in Richtung der Isolationsschicht (3) senkrecht zur Isolationsschicht (3) verlaufende Seitenkanten (14) aufweisen, wobei das Leistungshalbleitermodul (1,1") einen gehausten Leistungshalbleiterschalter (10a, 10b) aufweist, der über eine zwischen dem gehausten Leistungshalbleiterschalter (10a, 10b) und der Metallblechanordnung (4) angeordnete Sinterschicht (9) mit der Metallblechanordnung (4) verbunden ist, wobei der gehauste Leistungshalbleiterschalter (10a, 10b) an seiner der Isolationsschicht (3) zugewandten Seite elektrisch leitende Anschlussflächen (12) aufweist, wobei die jeweilige Anschlussfläche (12) mit einem ihr zugeordneten jeweiligen Metallblechelement (5) verbunden ist.

2. Leistungshalbleitermodul nach Anspruch 1, **dadurch gekennzeichnet, dass** mindestens ein Metallblechelement (5) einen von der Isolationsschicht (3) weg verlaufenden Abschnitt (6,7,8) aufweist.

3. Leistungshalbleitermodul nach einem der vorhergehenden Ansprüche, **dadurch gekennzeichnet, dass** das Leistungshalbleitermodul (1, 1") ein elektrisches Widerstandselement (11) aufweist, das über eine zwischen dem Widerstandselement (11) und der Metallblechanordnung (4) angeordnete Sinterschicht (9) mit der Metallblechanordnung (4) verbunden ist.

4. Leistungshalbleitermodul nach einem der vorhergehenden Ansprüche, **dadurch gekennzeichnet, dass** das Leistungshalbleitermodul (1") ein Steueranschlusselement (7') und/oder ein Hilfsanschlusselement (8') aufweist, das mit der Metallblechanordnung (4) mittels einer Schweiß- oder Sinterverbindung verbunden ist.

5. Leistungshalbleitermodul nach einem der vorhergehenden Ansprüche, **dadurch gekennzeichnet, dass** die Metallblechanordnung (4) eine Dicke von 0,5 mm bis 1 mm aufweist.

6. Leistungshalbleitermodul nach einem der vorhergehenden Ansprüche, **dadurch gekennzeichnet, dass** der gehauste Leistungshalbleiterschalter (10a, 10b) als SMD-Bauelement ausgebildet ist.

7. Verfahren zur Herstellung eines Leistungshalbleitermoduls mit folgenden Verfahrensschritten:
a) Bereitstellen eines elektrisch leitenden Metallformkörpers (2) und einer strukturierten, elektrisch leitende Metallblechelemente (5) aufweisenden, Metallblechanordnung (4), wobei die Metallblechelemente (5) mittels einer, einstückig mit den Metallblechelementen (5) ausgebildeten, Metallblechelementverbindungsvorrichtung (16) miteinander verbunden sind,
b) Verbinden der Metallblechanordnung (4) mit dem Metallformkörper (2) über eine elektrisch nicht leitende Isolationsschicht (3),
c) Verbinden eines gehausten Leistungshalbleiterschalters (10a, 10b) mit der Metallblechanordnung (4) mittels einer Sinterverbindung (9), wobei der gehauste Leistungshalbleiterschalter (10a, 10b) an seiner der Isolationsschicht (3) zugewandten Seite elektrisch leitende Anschlussflächen (12) aufweist, wobei die jeweilige Anschlussfläche (12) mit einem ihr zugeordneten jeweiligen Metallblechelement (5) verbunden wird, und
d) Abtrennen der Metallblechelementverbindungsvorrichtung (16) von der Metallblechanordnung (4).

8. Verfahren nach Anspruch 7, **dadurch gekennzeichnet, dass** Verfahrensschritt d) zwischen Verfahrensschritt b) und Verfahrensschritt c) durchgeführt wird.

9. Verfahren nach Anspruch 7 oder 8, **dadurch gekennzeichnet, dass** zwischen Verfahrensschritt b) und Verfahrensschritt c), oder zwischen Verfahrensschritt c) und Verfahrensschritt d) ein Verbiegen eines Abschnitts (6,7,8) von mindestens einem Metallblechelement (5) von der Isolationsschicht (3) weg erfolgt.

## Claims

1. Power semiconductor module, wherein the power semiconductor module (1, 1") comprises an electrically conductive metal shaped body (2) and a structured metal sheet arrangement (4) comprising electrically conductive metal sheet elements (5), said metal sheet arrangement being connected to the metal shaped body (2) via an electrically non-conductive insulation layer (3), wherein the metal sheet elements (5) have side edges (14) extending perpendicular to the insulation layer (3) in the direction of the insulation layer (3), wherein the power semiconductor module (1, 1") comprises a packaged power semiconductor switch (10a, 10b), which is connected to the metal sheet arrangement (4) via a sintering layer (9) arranged between the packaged power semiconductor switch (10a, 10b) and the metal sheet arrangement (4), wherein the packaged power semiconductor switch (10a, 10b) has electrically conductive terminal surfaces (12) at its side facing the insulation layer (3), wherein the respective terminal surface (12) is connected to a respective metal sheet element (5) assigned thereto.

2. Power semiconductor module according to Claim 1, **characterized in that** at least one metal sheet element (5) has a section (6, 7, 8) extending away from the insulation layer (3).

3. Power semiconductor module according to either of the preceding claims, **characterized in that** the power semiconductor module (1, 1") comprises an electrical resistance element (11), which is connected to the metal sheet arrangement (4) via a sintering layer (9) arranged between the resistance element (11) and the metal sheet arrangement (4).

4. Power semiconductor module according to any of the preceding claims, **characterized in that** the power semiconductor module (1") comprises a control terminal element (7') and/or an auxiliary terminal element (8'), which is connected to the metal sheet arrangement (4) by means of a welding or sintering connection.

5. Power semiconductor module according to any of the preceding claims, **characterized in that** the metal sheet arrangement (4) has a thickness of 0.5 mm to 1 mm.

6. Power semiconductor module according to any of the preceding claims, **characterized in that** the packaged power semiconductor switch (10a, 10b) is embodied as an SMD component.

7. Method for producing a power semiconductor module comprising the following method steps:
a) providing an electrically conductive metal shaped body (2) and a structured metal sheet arrangement (4) comprising electrically conductive metal sheet elements (5), wherein the metal sheet elements (5) are connected to one another by means of a metal sheet element connecting device (16) embodied integrally with the metal sheet elements (5),
b) connecting the metal sheet arrangement (4) to the metal shaped body (2) via an electrically non-conductive insulation layer (3),
c) connecting a packaged power semiconductor switch (10a, 10b) to the metal sheet arrangement (4) by means of a sintering connection (9), wherein the packaged power semiconductor switch (10a, 10b) has electrically conductive terminal surfaces (12) at its side facing the insulation layer (3), wherein the respective terminal surface (12) is connected to a respective metal sheet element (5) assigned thereto, and
d) separating the metal sheet element connecting device (16) from the metal sheet arrangement (4).

8. Method according to Claim 7, **characterized in that** method step d) is carried out between method step b) and method step c).

9. Method according to Claim 7 or 8, **characterized in that** bending a section (6, 7, 8) of at least one metal sheet element (5) away from the insulation layer (3) is carried out between method step b) and method step c), or between method step c) and method step d).

## Revendications

1. Module semi-conducteur de puissance, dans lequel le module semi-conducteur de puissance (1, 1") comporte un corps moulé métallique (2) électriquement conducteur et un dispositif en tôle métallique (4) structuré qui présente des éléments en tôle métallique (5) électriquement conducteurs et est relié au corps moulé métallique (2) par une couche isolante (3) électriquement non conductrice, dans lequel les éléments en tôle métallique (5) présentent des bords latéraux (14) s'étendant perpendiculairement à la couche isolante (3) dans la direction de la couche isolante (3), dans lequel le module semi-conducteur de puissance (1, 1") comporte un commutateur semi-conducteur de puissance en boîtier (10a, 10b) qui est relié au dispositif en tôle métallique (4) par l'intermédiaire d'une couche frittée (9) disposée entre le commutateur semi-conducteur de puissance (10a, 10b) en boîtier et le dispositif en tôle métallique (4), dans lequel le commutateur semi-conducteur de puissance (10a, 10b) en boîtier présente sur sa face tournée vers la couche isolante (3) des surfaces de connexion (12) électriquement conductrices, dans lequel la surface de connexion (12) respective est reliée à un élément en tôle métallique (5) respectif qui lui est associé.

2. Module semi-conducteur de puissance selon la revendication 1, **caractérisé en ce qu'**au moins un élément en tôle métallique (5) présente une partie (6, 7, 8) s'écartant de la couche isolante (3).

3. Module semi-conducteur de puissance selon l'une des revendications précédentes, **caractérisé en ce que** le module semi-conducteur de puissance (1, 1") comporte un élément de résistance électrique (11) qui est relié au dispositif en tôle métallique (4) par une couche frittée (9) disposée entre l'élément de résistance (11) et le dispositif en tôle métallique (4).

4. Module semi-conducteur de puissance selon l'une des revendications précédentes, **caractérisé en ce que** le module semi-conducteur de puissance (1") comporte un élément de connexion de commande (7') et/ou un élément de connexion auxiliaire (8') qui est relié au dispositif en tôle métallique (4) par une liaison soudée ou frittée.

5. Module semi-conducteur de puissance selon l'une des revendications précédentes, **caractérisé en ce que** le dispositif en tôle métallique (4) présente une épaisseur comprise entre 0,5 mm et 1 mm.

6. Module semi-conducteur de puissance selon l'une des revendications précédentes, **caractérisé en ce que** le commutateur semi-conducteur de puissance (10a, 10b) en boîtier est réalisé sous la forme d'un composant SMD.

7. Procédé de fabrication d'un module semi-conducteur de puissance, comprenant les étapes suivantes :
a) fournir un corps moulé métallique (2) électriquement conducteur et un dispositif en tôle métallique (4) structuré comportant des éléments en tôle métallique (5) électriquement conducteurs, dans lequel les éléments en tôle métallique (5) sont reliés entre eux au moyen d'un dispositif de connexion d'éléments en tôle métallique (16) réalisé d'une seule pièce avec les éléments en tôle métallique (5),
b) relier le dispositif en tôle métallique (4) au corps moulé métallique (2) par une couche isolante (3) électriquement non conductrice,
c) relier un commutateur semi-conducteur de puissance (10a, 10b) en boîtier audit dispositif en tôle métallique (4) au moyen d'une liaison frittée (9), dans lequel le commutateur semi-conducteur de puissance (10a, 10b) en boîtier présente sur sa face tournée vers la couche isolante (3) des surfaces de connexion (12) électriquement conductrices, dans lequel la surface de connexion (12) respective est reliée à un élément en tôle métallique (5) respectif qui lui est associé, et
d) séparer le dispositif de liaison d'éléments en tôle métallique (16) du dispositif en tôle métallique (4).

8. Procédé selon la revendication 7, **caractérisé en ce que** l'étape de procédé d) est effectuée entre l'étape de procédé b) et l'étape de procédé c).

9. Procédé selon la revendication 7 ou 8, **caractérisé en ce qu'**une partie (6, 7, 8) d'au moins un élément en tôle métallique (5) est coudée de manière à être écartée de la couche isolante (3) entre l'étape de procédé b) et l'étape de procédé c), ou entre l'étape de procédé c) et l'étape de procédé d).
